# FASCICULE DE BREVET EUROPEEN

(11) **EP 1 944 393 B1**
(45) Date de publication et mention de la délivrance du brevet: **24.12.2014**
(21) Numéro de dépôt: 08300008.3
(22) Date de dépôt: 07.01.2008
(51) Int. Cl.: C30B 11/00, C30B 29/48

(54) **Dispositif pour réaliser la croissance d'un matériau semi-conducteur**
Vorrichtung zur Erkennung des Zuwachses eines Halbleitermaterials
Device for ensuring the growth of a semiconductor material

(30) Priorité: 10.01.2007 FR 0752615
(43) Date de publication de la demande: 16.07.2008
(73) Titulaire: SOCIETE FRANCAISE DE DETECTEURS, INFRAROUGES- SOFRADIR, F-92290 Chatenay Malabry (FR)
(72) Inventeur: PALTRIER, M. Sylvain, 38340 Voreppe (FR)
(74) Mandataire: Vuillermoz, Bruno

(56) Documents cités:
- EP-A- 1 460 153
- EP-A1- 1 114 884
- JP-A- 1 294 591
- JP-A- 7 291 782
- JP-A- 2006 036 550
- US-A- 4 264 385

## Description

### DOMAINE DE L'INVENTION

L'invention concerne un dispositif pour réaliser la croissance cristalline de composés semi-conducteur de type II-VI. Elle vise notamment la croissance de tels matériaux semi-conducteurs ternaires répondant à la formule générale CdₓZn₁₋ₓTe, où x peut prendre toutes valeurs comprises entre zéro et un.

L'invention trouve également application pour la croissance de composés de cette famille incorporant du sélénium en lieu et place au tellure, voire de composés quaternaires de formule CdₓZn₁₋ₓTe_{y}Se_{1-y}.

De manière générale, la présente invention s'applique à l'élaboration de tels matériaux semi-conducteurs réalisée en ampoule scellée, c'est-à-dire sous vide ou sous atmosphère contrôlée.

Les matériaux ainsi obtenus sont plus particulièrement destinés à servir de substrat d'épitaxie aux composés semi-conducteurs de formule générique CdHgTe bien connus pour la réalisation de détecteurs infrarouge. Les matériaux - objets de l'invention sont également susceptibles d'être exploité pour la réalisation de détecteur de rayons X ou gamma (γ).

### ETAT ANTERIEUR DE LA TECHNIQUE

La demande en matériaux semi-conducteurs monocristallins de taille suffisamment importante devient sans cesse croissante. Or, la réalisation de tels matériaux est antinomique avec une production satisfaisante sur le plan économique.

Parmi les difficultés rencontrées, on peut mentionner la faible conductivité thermique de ces matériaux, qui entrave l'évacuation des calories générées par la cristallisation, et conduit à des formes d'interface de croissance concave en direction du liquide, peu favorable à la mono cristallisation.

Ensuite, la présence parmi les constituants d'éléments volatiles, notamment le cadmium et le sélénium, implique, sauf à compliquer singulièrement les équipements, d'effectuer les opérations de croissance dans des ampoules scellées, étanches, en verre de silice principalement.

Il est connu de réaliser la croissance de matériaux cristallins à partir d'un bain liquide constitué par ledit matériau. Cette croissance s'effectue traditionnellement en ampoule scellée typiquement réalisée en silice portée à la température de fusion du bain en question. Différentes difficultés proviennent du procédé de réalisation de tels matériaux. Parmi ceux-ci, lorsque l'on souhaite obtenir une cristallisation maîtrisée du matériau, condition imposée pour ses fonctions ultérieures, notamment comme matériau détecteur performant, la synthèse des éléments simples chargés cadmium, tellure, zinc et éventuellement sélénium, doit être complète, et seul un chauffage au-delà du point de fusion du composé, typiquement dans une gamme un peu supérieure à 1.100°C peut le garantir.

Si cette technologie est simple à mettre en oeuvre et efficace, elle ne permet cependant pas, commodément en tout cas, d'effectuer la croissance à partir d'un germe monocristallin orienté, comme c'est le cas pour les semi-conducteurs classiques élémentaires, tels que le silicium, ou pour les semi-conducteurs composés, tels que l'arséniure de galium (AsGa). En effet, la surchauffe nécessaire à une synthèse complète hypothèque la sauvegarde du germe qui peut fondre.

Une autre difficulté rencontrée réside dans la propension des bains de matériaux en question à présenter le phénomène de surfusion, c'est-à-dire le phénomène par lequel un corps demeure liquide à une température inférieure à son point de fusion. Il est bien connu que quand la surfusion cesse, c'est-à-dire lors de la rupture de l'équilibre métastable qui s'était instauré, la solidification subséquente s'effectue en général de manière brutale et anarchique, aboutissant à la réalisation d'un poly-cristal à petits grains, de mauvaise qualité. Le solide en résultant peut être de surcroît de masse relativement importante en fonction de l'ampleur de la surfusion, qui peut atteindre quelques dizaines de degrés C.

Ainsi, ce phénomène de surfusion altère le rendement cristallin et surtout la qualité cristallographique du solide en résultant, en tout cas de nature insuffisante pour un grand nombre d'applications envisagées.

Ce problème lié à la surfusion a été clairement identifié par exemple dans le document EP-A-1 114 884.

La solution qu'il préconise pour s'affranchir de ce phénomène réside essentiellement dans le dépôt au fond du creuset recevant le bain liquide d'une couche de matériau solide surmontée par le bain liquide, et dans le contrôle très précis et très strict des conditions de pression et de température du four de chauffage au sein duquel est placée l'ampoule scellée renfermant ledit creuset, le gradient de température étant maintenu inférieur à 10°C par centimètre.

En d'autres termes, les conditions de réalisation de la croissance du monocristal sont particulièrement draconiennes et difficiles dans la pratique à industrialiser.

De manière générale, l'état antérieur de la technique semble montrer que les meilleurs résultats en termes de qualité monocristalline du matériau à réaliser sont obtenus quand la cristallisation est conduite depuis la surface du bain en direction du fond de celui-ci. La nucléation, c'est-à-dire la constitution du germe constituant le centre de développement initial de la structure cristallographique que l'on souhaite obtenir joue donc un rôle essentiel et doit avoir lieu en surface.

On a ainsi décrit dans le document JP 7291782 un procédé mettant en oeuvre ce principe général. Il y est décrit l'association d'un homo-germe en CdTe flottant sur son bain de croissance, et initiant la cristallisation à partir de la surface supérieure du bain. Cependant, cette technique suppose que le germe en CdTe solide flotte sur son liquide. Or, en raison des densités très proches de la phase solide et de la phase liquide de ce matériau, cette exigence n'est réalisable qu'en utilisant un germe de diamètre sensiblement égal au diamètre du creuset, générant de fait deux difficultés particulières :
- la première difficulté suppose que l'on puisse disposer d'un tel germe de suffisamment grand diamètre;
- la seconde difficulté vise à éviter la fusion complète du germe lors des étapes de chauffage préalables à la croissance, ne serait-ce que pour arriver à liquéfier le bain. En effet, on observe une immersion quasi-totale du germe dans le bain en raison de la proximité des densités respectives du liquide et du solide, de sorte que pour éviter la fusion totale du germe, la maîtrise des conditions thermiques est là encore fondamentale pour ne pas aboutir à la fusion du germe, altérant alors la nucléation qu'il est sensé engendrer.

Bien sur dans un tel cas, la synthèse directe avec surchauffe à partir des éléments constitutifs est exclue et doit être conduite préalablement dans une autre ampoule, avec en corollaire toute la complexité que cela induit.

On conçoit de fait les difficultés que rencontre l'homme du métier pour aboutir à la réalisation d'une synthèse de monocristaux de semi-conducteurs, notamment appartenant à la famille II - VI.

La présente invention vise à favoriser la genèse de tels monocristaux.

### EXPOSE DE L'INVENTION

L'invention se propose de mettre en oeuvre le procédé de genèse de monocristaux semi-conducteurs réalisés au sein d'une ampoule scellée selon les procédés décrits précédemment, mais favorisant l'étape de nucléation en mettant en oeuvre un corps flottant sur le bain liquide à la fois inerte chimiquement et thermiquement, de telle sorte à permettre la croissance du solide en soutenant celui-ci au fur et à mesure de sa croissance à la surface du bain liquide.

En d'autres termes, l'invention concerne un dispositif pour réaliser la croissance du matériau semi-conducteur à partir d'un bain liquide dudit semi-conducteur placé dans une ampoule scellée sous vide ou sous atmosphère contrôlée, ladite ampoule étant soumise à un gradient de température suffisant pour tout d'abord maintenir le bain à l'état liquide, puis induire sa cristallisation progressive de la surface du bain en direction du fond.

Ce dispositif se caractérise en ce qu'il comporte en outre un élément susceptible de flotter à la surface dudit bain, et muni d'un alésage sensiblement central, destiné d'une part, à recevoir un germe ou à permettre la nucléation conduisant à la réalisation d'un germe, et d'autre part, à supporter ledit germe au dessus du bain tout en le maintenant en contact avec ledit bain afin de permettre la poursuite de la cristallisation à partir de ce germe par abaissement du gradient de température.

En d'autres termes, en raison de la présence de l'alésage central, voire co-axial avec l'axe de révolution du creuset, il s'opère un abaissement de température au niveau de cet alésage engendrant la solidification spontanée d'un germe polycristallin contribuant ensuite à favoriser la croissance cristalline dudit semi-conducteur dans toute la masse du bain.

Selon une variante de l'invention, on positionne préalablement au niveau de cet alésage central un germe de croissance, donc solide, placé de telle sorte qu'il soit en contact avec le bain liquide sans cependant lui permettre de s'y immerger totalement ou quasiment totalement, ainsi qu'il le ferait naturellement sous son propre poids. Ce germe induit donc, comme dans le cas précédent la croissance cristalline du semi-conducteur dans toute la masse du bain.

Selon l'invention, cet élément flottant est réalisé en un matériau réfractaire inerte chimiquement et thermiquement, par exemple choisi dans le groupe comprenant la silice, l'alumine, le carbure de silicium, le nitrure d'aluminium et le carbone sous toutes ses formes, mais préférentiellement sous forme graphite.

Avantageusement, cet élément occupe sensiblement toute la surface supérieure du bain, à l'exception de l'alésage central de telle sorte à réduire le plus possible les effets de rayonnement thermique inhérents à la température du bain, propre ainsi à éviter les phénomènes de fusion du solide en cours de constitution.

### BREVE DESCRIPTION DES DESSINS

La manière dont l'invention peut être réalisée et les avantages qui en découlent, ressortiront mieux des exemples de réalisation qui suivent, donnés à titre indicatif et non limitatif à l'appui des figures annexées.
La figure 1 est une représentation schématique du principe de l'invention selon une première forme de réalisation de l'invention mettant en oeuvre un germe préalable de croissance.
La figure 2 est une vue analogue à la figure 1 dans laquelle il y a solidification spontanée d'un germe polycristallin propre à initialiser à la croissance.

### DESCRIPTION DETAILLEE DE L'INVENTION

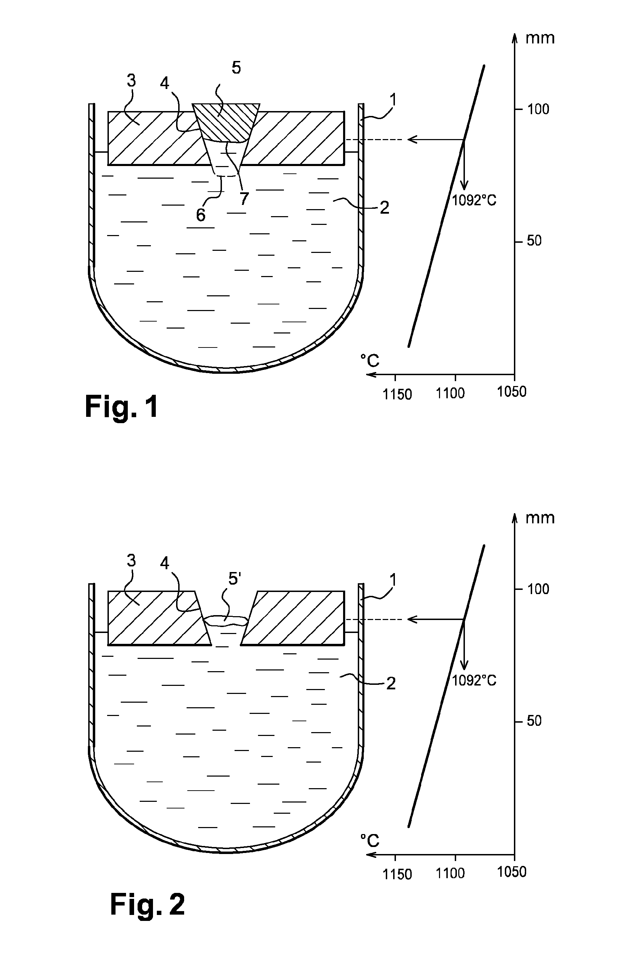

Il est décrit en relation avec la figure 1 un premier mode de réalisation de l'invention.

Celui-ci met en oeuvre de manière connue un creuset (1) réalisé en un matériau réfractaire et typiquement en silice.

Le diamètre de ce creuset est par exemple de 90 mm. Celui-ci peut être placé dans une ampoule scellée non représentée, ou bien ladite ampoule peut elle-même faire fonction de creuset. Celle-ci est positionnée dans un four de chauffage, afin de soumettre l'ampoule à un gradient thermique tel que schématisé dans la partie droite de ladite figure 1.

On place dans ce creuset (1) une charge de CdTe qui, lorsque placée dans le four, et en raison du gradient thermique imposé par celui-ci, se trouve à l'état liquide, et donc à une température en l'espèce supérieure à 1.092 °C, température de fusion du composé CdTe.

Selon une caractéristique de l'invention, on positionne à la surface supérieure du bain liquide ainsi réalisé un cylindre de graphite (3), d'un diamètre voisin de 88 mm, c'est-à-dire très proche du diamètre interne du creuset (1).

Dans l'exemple décrit, ce cylindre de graphite présente une épaisseur de 15 mm. Il est muni d'un alésage tronconique (4), dont la petite base est dirigée vers le bas et débouchant donc dans le bain liquide, et la grande base vers le haut, ainsi qu'on peut bien l'observer sur la figure 1.

En raison de la densité du graphite, voisine de 2,2, celui-ci flotte sans difficulté à la surface du bain de CdTe, dont la densité est comprise entre 5 et 6. En outre, le carbone sous toutes ses formes est bien connu pour son inertie chimique, son caractère réfractaire, son inertie thermique, et présente en outre l'avantage par rapport à d'autres matériaux, tels que par exemple la silice, l'alumine, le nitrure d'aluminium ou le carbure de silicium, d'être facilement usinable, favorisant ainsi la réalisation de l'alésage tronconique (4).

Selon une caractéristique de l'invention, on positionne dans le tronc de cône ainsi défini, un germe (5) monocristallin en CdTe, de dimensions suffisantes pour être retenu par les parois de l'alésage, et cependant permettant son affleurement et même son contact avec la surface supérieure du bain (2).

On aura bien compris que le coeur de l'invention réside dans le maintien du germe selon les caractéristiques précédentes, et ce par tout moyen, le tronc de cône ne constituant qu'un mode de réalisation commode.

On a de fait représenté en pointillés la forme initiale du germe (5), c'est à dire préalablement à la fusion de la charge. Sous l'action de la température du bain, il se produit une fusion partielle du germe, jusqu à définir une nouvelle interface solide / liquide positionné à l'isotherme de fusion/solidification, et typiquement 1.092 °C du composé CdTe.

On conçoit de fait qu'une partie principale du germe (5) est maintenue hors du liquide, c'est-à-dire dans une zone où la température est inférieure au point de fusion, favorisant dès lors la croissance monocristalline du matériau semi-conducteur que l'on souhaite obtenir en faisant varier le gradient de température au fur et à mesure de la solidification du matériau en direction du bas, et plus précisément en abaissant globalement la température du gradient au fur et à mesure de la solidification du matériau.

La mise en oeuvre de ce procédé de réalisation de matériau monocristallin est réalisé sans ajustements thermiques laborieux en raison tout d'abord, de la mise en oeuvre du cylindre en graphite (3) et de la conformation de son alésage (4), contrairement à l'art antérieur dans lequel le germe flotte librement sur le bain, la partie émergeante du solide étant alors extrêmement ténue en raison de l'écart très réduit des densités solide liquide, le flotteur (3) permettant ainsi d'éviter la fusion complète du germe.

Selon une autre caractéristique avantageuse de l'invention, en raison des dimensions du cylindre, c'est-à-dire sensiblement celles du creuset en termes de diamètre, on limite les phénomènes de rayonnement et donc les transferts thermiques corollaires provenant du bain liquide (2), susceptibles d'induire une température proche de la température de fusion au dessus dudit bain liquide, et partant, la fusion du germe.

Au surplus, la mise en oeuvre de graphite, connus pour sa facilité d'usinage, permet de modifier les phénomènes de transferts thermiques principalement par conduction, et ainsi d'infléchir la forme et la convexité de l'interface solide/liquide. On peut notamment utiliser du graphite pyrolytique, mieux connu sous la dénomination « Pyro-carbone » distribué par la société LE CARBONE LORRAINE en raison de son anisotropie thermique prononcée, propre à établir des transferts thermiques très différents radialement et axialement, et ainsi favoriser la monocristallisation.

Si le cylindre (3) a été décrit en mettant en oeuvre un matériau simple, on peut envisager la mise en oeuvre d'un support flottant de nature composite, par exemple constitué en partie de graphite dense et en partie en feuilles de graphite.

Un tel matériau composite est connu sous la dénomination commerciale « Papyex », également commercialisé par la société LE CARBONE LORRAINE.

Dans le même esprit, on peut également utiliser du graphite, revêtu après usinage et notamment après réalisation de l'alésage, de carbure de silicium ou d'un dépôt mince de Pyro-carbone, susceptible de modifier la mouillabilité du liquide (tension superficielle) vis à vis du flotteur selon l'invention, et là encore, d'optimiser l'interface de croissance au début du processus.

On conçoit l'intérêt de cette première forme de réalisation qui permet de partir d'un germe de petite dimension, donc réalisable plus facilement, et surtout, de s'affranchir des phénomènes de surfusion, puisque partant d'un germe déjà constitué, maintenu au dessus du bain liquide, lesdits phénomènes ne se manifestant plus.

Selon une autre forme de réalisation en relation avec la figure 2, le principe mis en oeuvre demeure identique à l'exception toutefois de laquelle, le germe initiateur de nucléation n'est pas rapporté sur le cylindre, mais créé in situ par abaissement en température selon un gradient thermique propre à provoquer primitivement la cristallisation de la surface du bain.

Plus précisément, après une surchauffe du creuset d'environ une dizaine de °C par exemple, au dessus du point de fusion du semi-conducteur considéré, la charge utile est abaissée en température selon un gradient tel qu'on aboutit à la cristallisation de la surface du bain.

En raison de la présence du corps flottant du type décrit précédemment, la première fraction solidifiée est générée préférentiellement puis maintenue au centre du bain dans l'alésage ménagé dans le corps flottant. De ce fait, il se créé un germe, faisant ensuite fonction d'initiateur de la cristallisation qui va suivre, obtenu par abaissement en température de l'ensemble du creuset (1) selon un gradient thermique déterminé, analogue à celui mis en oeuvre dans la première forme de réalisation décrite, avec sélection naturelle des directions de cristallisation favorable et production d'un lingot à gros grain, voire monocristallin.

On conçoit de fait tout l'intérêt du dispositif de l'invention, qu'il s'agisse d'une variante ou d'une autre, dans la mesure où elle permet de favoriser la cristallisation selon des directions privilégiées d'un matériau semi-conducteur sans nécessiter de contrôle précis et contraignant de tout l'aspect thermique du procédé mis en oeuvre, et permettant le cas échéant, de provoquer une surchauffe de l'enceinte du creuset au-delà de la température de fusion du bain liquide, lorsqu'elle peut être jugée nécessaire par l'opérateur.

Dans ce second cas, il n'est plus nécessaire de disposer préalablement d'une charge synthétisée à fondre pour constituer le bain de matériau semi-conducteur, car il est possible alors de réaliser directement cette synthèse in situ à partir des éléments constitutifs du composé.

## Revendications

1. Dispositif pour réaliser la croissance d'un matériau semi-conducteur, notamment de type II-VI, à partir d'un bain liquide dudit semi-conducteur placé dans une ampoule scellée sous vide ou sous atmosphère contrôlée, ladite ampoule étant soumise à un gradient de température suffisante pour tout d'abord maintenir le bain à l'état liquide, puis induire sa cristallisation progressive de la surface en direction du fond, ***caractérisé* en ce qu'**il comporte en outre un élément (3) susceptible de flotter à la surface dudit bain, et muni d'un alésage (4) sensiblement central, destiné d'une part, à recevoir un germe (5) ou à permettre la nucléation conduisant à la réalisation d'un germe (5'), et d'autre part à supporter ledit germe (5, 5') au dessus du bain tout en le maintenant en contact avec ledit bain afin de permettre la poursuite de la cristallisation à partir de ce germe (5, 5') par abaissement du gradient de température.

2. Dispositif pour réaliser la croissance d'un matériau semi-conducteur selon la revendication 1, ***caractérisé* en ce que** l'alésage (4) de l'élément flottant (3) est de forme tronconique, dont la petite base est dirigée vers le bas et débouchant dans le bain liquide, et dont la grande base est dirigée vers le haut.

3. Dispositif pour réaliser la croissance d'un matériau semi-conducteur selon l'une des revendications 1 et 2, ***caractérisé* en ce que** l'on positionne préalablement au niveau de l'alésage central (4) un germe de croissance (5), donc solide, placé de telle sorte qu'il soit en contact avec le bain liquide sans cependant lui permettre de s'y immerger totalement ou quasiment totalement.

4. Dispositif pour réaliser la croissance d'un matériau semi-conducteur selon l'une des revendications 1 à 3, ***caractérisé* en ce que** l'élément flottant (3) est réalisé en un matériau réfractaire inerte chimiquement et thermiquement, choisi dans le groupe comprenant la silice, l'alumine, le carbure de silicium, le nitrure d'aluminium et le carbone sous toutes ses formes.

5. Dispositif pour réaliser la croissance d'un matériau semi-conducteur selon la revendication 4, ***caractérisé* en ce que** l'élément flottant (3) est réalisé en graphite.

6. Dispositif pour réaliser la croissance d'un matériau semi-conducteur selon la revendication 5, ***caractérisé* en ce que** l'élément flottant (3) est usiné, afin d'optimiser les transferts thermiques.

7. Dispositif pour réaliser la croissance d'un matériau semi-conducteur selon l'une des revendications 5 et 6, ***caractérisé* en ce que** l'élément flottant (3) est réalisé en graphite pyrolytique.

8. Dispositif pour réaliser la croissance d'un matériau semi-conducteur selon la revendication 5, ***caractérisé* en ce que** l'élément flottant (3) est réalisé en partie de graphite dense et en partie en feuilles de graphite.

9. Dispositif pour réaliser la croissance d'un matériau semi-conducteur selon la revendication 4, ***caractérisé* en ce que** l'élément flottant (3) est réalisé en graphite, revêtu après usinage et notamment après réalisation de l'alésage, de carbure de silicium ou d'un dépôt mince de carbone pyrolytique.

10. Dispositif pour réaliser la croissance d'un matériau semi-conducteur selon l'une des revendications 1 à 9, ***caractérisé* en ce que** l'élément flottant (3) occupe sensiblement toute la surface supérieure du bain, à l'exception de l'alésage central de telle sorte à réduire le plus possible les effets de rayonnement thermique inhérents à la température du bain.

## Patentansprüche

1. Vorrichtung zum Züchten eines Halbleitermaterials, insbesondere vom Typ II-VI, ausgehend von einem Flüssigbad des Halbleitermaterials, das in einem unter Vakuum oder unter kontrollierter Atmosphäre verschlossenen Gefäß angeordnet ist, wobei das Gefäß einem Temperaturgradienten ausgesetzt wird, der ausreicht, um zunächst das Bad im flüssigen Zustand zu halten, dann seine allmähliche Kristallisierung der Oberfläche in Richtung Boden einzuleiten, **dadurch gekennzeichnet, dass** sie ferner ein Element (3) aufweist, das an der Oberfläche des Bads schwimmen kann und mit einer im Wesentlichen mittigen Bohrung (4) versehen ist, die dazu bestimmt ist, einerseits einen Keim (5) aufzunehmen oder die Keimbildung zu gestatten, die zur Bildung eines Keims (5') führt, und andererseits den Keim (5, 5') über dem Bad abzustützen und ihn dabei in Kontakt mit dem Bad zu halten, um die Fortsetzung der Kristallisierung ausgehend von diesem Keim (5, 5') durch Senken des Temperaturgradienten zu gestatten.

2. Vorrichtung zum Züchten eines Halbleitermaterials nach Anspruch 1, **dadurch gekennzeichnet, dass** die Bohrung (4) des schwimmenden Elements (3) eine Kegelstumpfform hat, deren Deckfläche nach unten gerichtet ist und in das Flüssigbad mündet und deren Grundfläche nach oben gerichtet ist.

3. Vorrichtung zum Züchten eines Halbleitermaterials nach einem der Ansprüche 1 und 2, **dadurch gekennzeichnet, dass** zuvor im Bereich der mittigen Bohrung (4) ein Wachstumskeim (5) positioniert wird, der fest ist und so angeordnet wird, dass er mit dem Flüssigbad in Kontakt gelangt, jedoch ohne vollständig bzw. quasi vollständig darin eintauchen zu können.

4. Vorrichtung zum Züchten eines Halbleitermaterials nach einem der Ansprüche 1 bis 3, **dadurch gekennzeichnet, dass** das schwimmende Element (3) aus einem chemisch und thermisch inerten, hitzebeständigen Material hergestellt ist, das ausgewählt ist aus der Gruppe umfassend Siliciumdioxid, Aluminiumoxid, Siliciumkarbid, Aluminiumnitrid und Kohlenstoff in all seinen Formen.

5. Vorrichtung zum Züchten eines Halbleitermaterials nach Anspruch 4, **dadurch gekennzeichnet, dass** das schwimmende Element (3) aus Graphit hergestellt ist.

6. Vorrichtung zum Züchten eines Halbleitermaterials nach Anspruch 5, **dadurch gekennzeichnet, dass** das schwimmende Element (3) spanend bearbeitet wird, um die Wärmeübertragungen zu optimieren.

7. Vorrichtung zum Züchten eines Halbleitermaterials nach einem der Ansprüche 5 und 6, **dadurch gekennzeichnet, dass** das schwimmende Element (3) aus pyrolytischem Graphit hergestellt ist.

8. Vorrichtung zum Züchten eines Halbleitermaterials nach Anspruch 5, **dadurch gekennzeichnet, dass** das schwimmende Element (3) teilweise aus dichtem Graphit und teilweise aus Graphitblättern hergestellt ist.

9. Vorrichtung zum Züchten eines Halbleitermaterials nach Anspruch 4, **dadurch gekennzeichnet, dass** das schwimmende Element (3) aus Graphit hergestellt ist, das nach Bearbeitung und insbesondere nach Einbringung der Bohrung mit Siliciumkarbid oder einem dünnen Auftrag aus pyrolytischem Kohlenstoff überzogen wird.

10. Vorrichtung zum Züchten eines Halbleitermaterials nach einem der Ansprüche 1 bis 9, **dadurch gekennzeichnet, dass** das schwimmende Element (3) im Wesentlichen die gesamte obere Fläche des Bads einnimmt mit Ausnahme der mittigen Bohrung, so dass die mit der Temperatur des Bads zusammenhängenden Wärmestrahlungseffekte so weit wie möglich vermindert werden.

## Claims

1. Device for producing the growth of a semiconductor material, in particular of type II-VI, from a melt of the said semiconductor placed in a sealed bulb under vacuum or under controlled atmosphere, the said bulb being subjected to a sufficient temperature gradient for first maintaining the melt in the liquid state, then causing its progressive crystallization from the surface towards the bottom, **characterized in that** it further comprises an element (3) capable of floating on the surface of the said melt, and equipped with a substantially central bore (4), intended on the one hand for receiving a seed crystal (5) or for permitting the nucleation leading to the preparation of a seed crystal (5'), and also of supporting the said seed crystal (5, 5') above the melt while maintaining it in contact with the said melt in order to permit the continued crystallization from the said seed crystal (5, 5') by lowering the temperature gradient.

2. Device for producing the growth of a semiconductor material according to Claim 1, **characterized in that** the bore (4) of the floating element (3) has a frustoconical shape, whereof the small base is directed downwards and terminates in the melt, and whereof the large base is directed upwards.

3. Device for producing the growth of a semiconductor material according to Claim 1, **characterized in that** a growth seed crystal (5), hence solid, is previously positioned in the central bore (4), placed so that it is in contact with the melt but without allowing it to be completely or almost completely immersed therein.

4. Device for producing the growth of a semiconductor material according to Claim 1, **characterized in that** the floating element (3) is made from a chemically and thermally inert refractory material, selected from the group comprising silica, alumina, silicon carbide, aluminium nitride and carbon in all its forms.

5. Device for producing the growth of a semiconductor material according to Claim 4, **characterized in that** the floating element (3) is made from graphite.

6. Device for producing the growth of a semiconductor material according to Claim 5, **characterized in that** the floating element (3) is machined, in order to optimize the heat transfers.

7. Device for producing the growth of a semiconductor material according to Claim 5, **characterized in that** the floating element (3) is made from pyrolytic graphite.

8. Device for producing the growth of a semiconductor material according to Claim 5, **characterized in that** the floating element (3) is made partly from dense graphite and partly from sheet graphite.

9. Device for producing the growth of a semiconductor material according to Claim 4, **characterized in that** the floating element (3) is made from graphite, coated after machining and particularly after preparing the bore, with silicon carbide or with a thin deposit of pyrolytic carbon.

10. Device for producing the growth of a semiconductor material according to Claim 1, **characterized in that** the floating element (3) substantially occupies the whole upper surface of the melt, with the exception of the central bore, in order to minimize the effects of the heat radiation inherent in the temperature of the melt.
